# EUROPÄISCHE PATENTSCHRIFT

(11) **EP 1 081 254 B1**
(45) Veröffentlichungstag und Bekanntmachung des Hinweises auf die Patenterteilung: **21.11.2001**
(21) Anmeldenummer: 00117291.5
(22) Anmeldetag: 17.08.2000
(51) Int. Cl.: C30B 15/04, C30B 15/00, C30B 13/00, C30B 29/06

(54) **Verfahren zur Herstellung von mit Stickstoff dotierten Halbleiterscheiben**
Process for producing nitrogen doped semiconductor wafers
Procédé pour la production des plaquettes de sémiconducteurs dopés à l'azote

(30) Priorität: 02.09.1999 DE 19941902
(43) Veröffentlichungstag der Anmeldung: 07.03.2001
(73) Patentinhaber: Wacker Siltronic Gesellschaft für Halbleitermaterialien Aktiengesellschaft, 84489 Burghausen (DE)
(72) Erfinder: von Ammon, Wilfied, Dr., 5122 Hochburg/Ach (AT); Weidner, Herbert, 84533 Haiming (DE); Zemke, Dirk, Dr., 84533 Marktl (DE); Frey, Christoph, Dr., 84489 Burghausen (DE)
(74) Vertreter: Rimböck, Karl-Heinz, Dr.

(56) Entgegenhaltungen:
- EP-A- 0 170 788
- EP-A- 0 829 559
- KAISER: "Nitrogen in silicon" JOURNAL OF APPLIED PHYSICS., Bd. 30, Nr. 5, 1959, Seiten 427-431, XP000960804 AMERICAN INSTITUTE OF PHYSICS. NEW YORK., US ISSN: 0021-8979

## Beschreibung

Gegenstand der Erfindung ist ein Verfahren zur Herstellung von mit Stickstoff dotierten Halbleiterscheiben, wobei der Stickstoff von einem Dotierstoffgas stammt, das NH₃ enthält. Das Verfahren umfaßt das Ziehen des Einkristalls aus einer Schmelze von Halbleitermaterial und das Abtrennen der mit Stickstoff dotierten Halbleiterscheiben vom gezogenen Einkristall.

Es ist üblich, Halbleiterscheiben von einem Einkristall abzutrennen. Der Einkristall wird durch Zonenziehen (floating zone method, FZ-Methode) oder durch Ziehen von einer Schmelze, die in einem Tiegel enthalten ist (Czochralski-Methode, CZ-Methode), erhalten. In der US-4,591,409 ist ein Verfahren beschrieben, das sich zum Ziel setzt, eine gleichmäßige Verteilung von Stickstoff in einem nach der CZ-Methode gezogenen Einkristall zu erreichen. Gemäß diesem Verfahren ist die Anwesenheit eines Gases wie Distickstoffoxid während des Ziehvorganges zu gewährleisten. In einem wissenschaftlichen Artikel wird über Versuche berichtet, Stickstoffgas oder ein Gasgemisch von Helium und NH₃ mit geschmolzenem Silicium zur Reaktion zu bringen (W.Kaiser, C.D.Thurmond, J.Appl.Phys. 30, No.3, 427-431 (1959)). Aus dem Artikel kann jedoch keine Anleitung hergeleitet werden, wie Halbleiterscheiben in reproduzierbarer Weise erhalten werden können, die Stickstoff mit vorbestimmter Konzentration und in gleichmäßiger Verteilung enthalten. Eine reproduzierbare Dotierung ist wegen der thermischen Instabilität von NH₃ nicht ohne geeignete Maßnahmen erzielbar.

Gegenstand der Erfindung ist ein Verfahren zur Herstellung von mit Stickstoff dotierten Halbleiterscheiben, wobei der Stickstoff von einem Dotierstoffgas stammt, das NH₃ enthält, umfassend das Ziehen des Einkristalls aus einer Schmelze von Halbleitermaterial, wobei das Dotierstoffgas dem Halbleitermaterial zugeleitet wird, und das Abtrennen der mit Stickstoff dotierten Halbleiterscheiben vom gezogenen Einkristall, das dadurch gekennzeichnet ist, daß das Dotierstoffgas dem Halbleitermaterial höchstens so lange zugeleitet wird, bis mit dem Ziehen eines Teils des Einkristalls begonnen wird, von dem die Halbleiterscheiben abgetrennt werden.

Im Vergleich mit dem in dem genannten US-Patent beschriebenen Verfahren genießt dieses Verfahren den Vorteil, daß die axiale Verteilung von Stickstoff im Einkristall gleichmäßiger ist, das heißt, der axiale Gradient der Stickstoff-Konzentration im Einkristall weniger ausgeprägt ist. Darüber hinaus wird durch das Verfahren vermieden, daß vom Dotierstoffgas stammender Sauerstoff graphithaltige Einbauten in der Ziehanlage korrodiert, CO bildet und in der Folge das Halbleitermaterial mit Kohlenstoff verunreinigt.

Erfindungsgemäß wird vorgeschlagen, das Halbleitermaterial während des Ziehens des Einkristalls in einer Ziehanlage höchstens solange mit einem Dotierstoffgas zu beaufschlagen, bis ein Teil des Einkristalls gezogen wird, dessen Weiterverarbeitung zu Halbleiterscheiben vorgesehen ist. Bei diesem Teil des Einkristalls handelt es sich um den gesamten oder um nahezu den gesamten Abschnitt des Einkristalls, der eine zylindrische Form besitzt. Die an diesen Abschnitt angrenzenden konusförmigen Abschnitte werden zweckmäßigerweise nicht zu Halbleiterscheiben weiterverarbeitet. Nach dem Beenden des Zuleitens von Dotierstoffgas zum Halbleitermaterial wird der Einkristall in herkömmlicher Weise z. B. in einer reinen Inertgasatmosphäre fertig gezogen.

Falls nach der CZ-Methode gezogen wird, sollte vorzugsweise frühestens dann begonnen werden, das Halbleitermaterial mit dem Dotierstoffgas zu beaufschlagen, wenn das in einem Tiegel enthaltene Halbleitermaterial vollständig geschmolzen ist. Falls nach der FZ-Methode gezogen wird, sollte frühestens dann begonnen werden, das Halbleitermaterial mit dem Dotierstoffgas zu beaufschlagen, wenn mit dem Ziehen eines sogenannten Dünnhalses bereits begonnen worden ist, vorzugsweise wenn das Ziehen des Dünnhalses beendet ist und ein Anfangskonus gezogen wird. Die Zufuhr von Dotierstoffgas zum Halbleitermaterial wird in diesem Fall vorzugsweise beendet, bevor mit dem Ziehen des zylindrischen Abschnitts des Einkristalls begonnen wird.

Das Dotierstoffgas wird mit einer bestimmten Durchflussgeschwindigkeit und einer bestimmten Konzentration an NH₃ für eine bestimmte Zeit durch die Ziehanlage geleitet. Vorzugsweise wird das Dotierstoffgas dem Halbleitermaterial in gekühltem Zustand zugeführt. Bevorzugt ist auch, daß der Dotierstoffgasstrom zur freien Oberfläche des schmelzflüssigen Halbleitermaterials geleitet wird. Beispielsweise kann der Gasstrom durch ein gekühltes Rohr (insbesondere bei der FZ-Methode) oder durch einen den zu ziehenden Einkristall umgebenden Wärmeschild (insbesondere bei der CZ-Methode) dicht an die freie Oberfläche der Schmelze herangeführt werden. Des weiteren hat es sich bei der CZ-Methode als vorteilhaft für eine axial gleichmäßige Verteilung von Stickstoff im Einkristall erwiesen, wenn der Einkristall in einem Magnetfeld gezogen wird, dessen Feldlinien axial ausgerichtet sind.

Es wurde festgestellt, daß die Gegenwart einer zu hohen Konzentration von Stickstoff in der Schmelze das Wachsen eines Einkristalls verhindern kann und daß in der Schmelze gelöster Stickstoff praktisch nicht mehr aus der Schmelze entweichen kann. Es ist daher besonders bevorzugt, die Konzentration von Stickstoff im Einkristall nicht über einen Grenzwert von 5*10¹⁵ at/cm³, vorzugsweise nicht über 3*10¹⁵ at/cm³ ansteigen zu lassen. Dementsprechend sind die Durchflussrate an Dotierstoffgas durch die Ziehkammer, die Konzentration an NH₃ im Dotierstoffgas und die Zeit der Beaufschlagung des Halbleitermaterials mit Dotierstoffgas so zu wählen, daß der Grenzwert möglichst nicht überschritten wird. Typischerweise sollte z. B. zum Ziehen eines Einkristalls nach der CZ-Methode mit einem Gewicht von 30 bis 120 kg eine Gesamtmenge von 0,01 bis 20 Normliter, vorzugsweise 0,1 bis 3 Normliter NH₃ genügen, da Stickstoff von ungefähr 25 bis 50% des angebotenen NH₃ bei effektiver, zur Schmelcenoberfläche gerichteter Gasführung vom Halbleitermaterial aufgenommen wird. Bei weniger effektiver Gasführung steigt der Bedarf an Dotierstoffgas entsprechend an.

Als Dotierstoffgas ist ein NH₃ enthaltendes Gas vorgesehen, vorzugsweise eine Mischung von NH₃ und einem Inertgas, besonders bevorzugt eine NH₃/Argon-Mischung.

Ein in der beschriebenen Weise hergestellter Einkristall wird auf bekannte Weise, vorzugsweise mit Hilfe einer Drahtsäge oder einer Innenlochsäge in Halbleiterscheiben gewünschter Dicke geteilt. Üblicherweise wird nur der Abschnitt des Einkristalls, der eine im wesentlichen zylindrische Form besitzt vollständig oder teilweise zu Halbleiterscheiben geteilt.

### Beispiel:

Es wurde ein Einkristall mit einem Durchmesser von 200 mm nach der CZ-Methode gezogen. Vor Beginn der Phase des zylindrischen Wachstums des Einkristalls wurde ein Gasgemisch von 0,2% NH₃ und Argon 60 min mit einer Durchflußrate durch die Ziehkammer von 3,6 1/min über die Schmelze geleitet. Zu Beginn der zylindrischen Wachstumsphase wurde die Ziehkammer nur noch mit Argon gespült. Eine anschließende Untersuchung des Einkristalls ergab eine Konzentration von Stickstoff von ca. 1*10¹⁴ at/cm³ im Bereich des an den Impfkristall angrenzenden Abschnitts des Einkristalls und einen nur entsprechend dem Segregationskoeffizienten von ca. 10⁻³ ansteigenden Wert der Stickstoff-Konzentration zum Ende dieses Abschnitts des Einkristalls.

## Patentansprüche

1. Verfahren zur Herstellung von mit Stickstoff dotierten Halbleiterscheiben, wobei der Stickstoff von einem Dotierstoffgas stammt, das NH₃ enthält, umfassend das Ziehen des Einkristalls aus einer Schmelze von Halbleitermaterial, wobei das Dotierstoffgas dem Halbleitermaterial zugeleitet wird, und das Abtrennen der mit Stickstoff dotierten Halbleiterscheiben vom gezogenen Einkristall, **dadurch gekennzeichnet, daß** das Dotierstoffgas dem Halbleitermaterial höchstens so lange zugeleitet wird, bis mit dem Ziehen eines Teils des Einkristalls begonnen wird, von dem die Halbleiterscheiben abgetrennt werden.

2. Verfahren nach Anspruch 1, **dadurch gekennzeichnet, daß** das Dotierstoffgas durch eine Ziehkammer geleitet wird und eine Durchflußgeschwindigkeit des Dotierstoffgases durch die Ziehkammer und eine Konzentration von NH₃ im Dotierstoffgas eingestellt werden, die derart bemessen sind, daß die Konzentration an Stickstoff, mit dem die Halbleiterscheiben dotiert sind, höchstens 5*10¹⁵ at/cm³ betragen kann.

3. Verfahren nach Anspruch 1 oder Anspruch 2, **dadurch gekennzeichnet, daß** die Menge an NH₃, die beim Ziehen eines Einkristalls nach der CZ-Methode von 30 bis 120 kg Gewicht dem Halbleitermaterial zugeleitet wird, 0,01 bis 20 Normliter beträgt.

4. Verfahren nach einem der Ansprüche 1 bis 3, **dadurch gekennzeichnet, daß** der Einkristall nach der CZ-Methode gezogen wird und mit dem Zuleiten des Dotierstoffgases zum Halbleitermaterial frühestens dann begonnen wird, wenn das in einem Tiegel enthaltene Halbleitermaterial geschmolzen ist.

5. Verfahren nach einem der Ansprüche 1 bis 4, **dadurch gekennzeichnet, daß** der Einkristall nach der CZ-Methode in einem axial ausgerichteten Magnetfeld gezogen wird.

6. Verfahren nach Anspruch 1 oder Anspruch 2, **dadurch gekennzeichnet, daß** der Einkristall nach der FZ-Methode gezogen wird und mit dem Zuleiten des Dotierstoffgases zum Halbleitermaterial frühestens dann begonnen wird, nachdem mit dem Ziehen eines Dünnhalses begonnen worden ist, und das Zuleiten von Dotierstoffgas spätestens beendet wird, bevor mit dem Ziehen eines zylindrischen Abschnitts des Einkristalls begonnen worden ist.

7. Verfahren nach einem der Ansprüche 1 bis 6, **dadurch gekennzeichnet, daß** eine Gasmischung als Dotierstoffgas durch die Ziehkammer geleitet wird, die NH₃ und Argon enthält.

8. Verfahren nach einem der Ansprüche 1 bis 7, **dadurch gekennzeichnet, daß** das Dotierstoffgas in gekühltem Zustand dem Halbleitermaterial zugeleitet wird.

9. Verfahren nach einem der Ansprüche 1 bis 8, **dadurch gekennzeichnet, daß** das Dotierstoffgas dicht über eine freie, schmelzflüssige Oberfläche des Halbleitermaterials geleitet wird.

## Claims

1. Process for producing nitrogen-doped semiconductor wafers, the nitrogen being derived from a dopant gas which contains NH₃, comprising the steps of pulling the single crystal from a pool of molten semiconductor material, the dopant gas being fed to the semiconductor material, and cutting the nitrogen-doped semiconductor wafers off the pulled single crystal, **characterized in that** the dopant gas is fed to the semiconductor material at most until pulling of part of the single crystal from which the semiconductor wafers are cut begins.

2. Process according to Claim 1, **characterized in that** the dopant gas is passed through a pulling chamber and a flow rate of the dopant gas through the pulling chamber and a concentration of NH₃ in the dopant gas are set in such a way that the concentration of nitrogen with which the semiconductor wafers are doped can be at most 5*10¹⁵ at/cm³.

3. Process according to Claim 1 or Claim 2, **characterized in that** the amount of NH₃ which is fed to the semiconductor material for pulling a single crystal with a weight of from 30 to 120 kg using the CZ method is from 0.01 to 20 litres (s.t.p.).

4. Process according to one of Claims 1 to 3, **characterized in that** the single crystal is pulled using the CZ method and the feed of the dopant gas to the semiconductor material is commenced at the earliest when the semiconductor material contained in a crucible has melted.

5. Process according to one of Claims 1 to 4, **characterized in that** the single crystal is pulled using the CZ method in an axially oriented magnetic field.

6. Process according to Claim 1 or Claim 2, **characterized in that** the single crystal is pulled using the FZ method, and the feed of the dopant gas to the semiconductor material commences at the earliest once pulling of a thin neck has commenced, and the feed of dopant gas is ended at the latest before the pulling of a cylindrical section of the single crystal has commenced.

7. Process according to one of Claims 1 to 6, **characterized in that** a gas mixture which contains NH₃ and argon is passed through the pulling chamber as dopant gas.

8. Process according to one of Claims 1 to 7, **characterized in that** the dopant gas is fed to the semiconductor material in the cooled state.

9. Process according to one of Claims 1 to 8, **characterized in that** the dopant. gas is passed closely over an open, molten surface of the semiconductor material.

## Revendications

1. Procédé pour la production de plaquettes de semiconducteur dopé à l'azote, l'azote étant issu d'un agent de dopage gazeux qui contient du NH₃, comprenant l'étirage du monocristal d'un matériau semiconducteur en fusion, l'agent de dopage gazeux étant amené au matériau semiconducteur, et la découpe des plaquettes de semiconducteur dopé à l'azote du monocristal étiré, **caractérisé en ce que** l'agent de dopage gazeux est amené au matériau semiconducteur au moins jusqu'au début de l'étirage d'une partie du monocristal duquel sont découpées les plaquettes de semiconducteur.

2. Procédé selon la revendication 1, **caractérisé en ce que** l'agent de dopage gazeux est amené à travers un puits d'étirage et une vitesse d'écoulement de l'agent de dopage gazeux est réglée par le puits d'étirage et une concentration de NH₃ dans l'agent de dopage gazeux, lesquels sont dimensionnés de telle manière que la concentration d'azote avec lequel sont dopées les plaquettes de semiconducteur peut s'élever au maximum à 5.10¹⁵ at/cm³.

3. Procédé selon la revendication 1 ou la revendication 2, **caractérisé en ce que** la quantité de NH₃ qui est amenée au matériau semiconducteur lors de l'étirage d'un monocristal selon la méthode CZ ayant un poids de 30 à 120 kg est de 0,01 à 20 litres normalisés.

4. Procédé selon l'une des revendications 1 à 3, **caractérisé en ce que** le monocristal est étiré selon la méthode CZ et que l'amenée de l'agent de dopage gazeux au matériau semiconducteur commence au plus tôt lorsque le matériau semiconducteur présent dans un creuset est fondu.

5. Procédé selon l'une des revendications 1 à 4, **caractérisé en ce que** le monocristal est étiré selon la méthode CZ dans un champ magnétique aligné dans le sens axial.

6. Procédé selon la revendication 1 ou la revendication 2, **caractérisé en ce que** le monocristal est étiré selon la méthode FZ et que l'amenée de l'agent de dopage gazeux au matériau semiconducteur commence au plus tôt lorsque l'étirage d'un col mince a commencé et l'amenée de l'agent de dopage gazeux au matériau semiconducteur se termine au plus tard avant de commencer l'extraction d'une section cylindrique du monocristal.

7. Procédé selon l'une des revendications 1 à 6, **caractérisé en ce qu'**un mélange gazeux contenant du NH₃ et de l'argon et faisant office d'agent de dopage gazeux est amené à travers le puits d'étirage.

8. Procédé selon l'une des revendications 1 à 7, **caractérisé en ce que** l'agent de dopage gazeux est amené à l'état froid au matériau semiconducteur.

9. Procédé selon l'une des revendications 1 à 8, **caractérisé en ce que** l'agent de dopage gazeux est amené de manière concentrée sur une surface liquide fondue libre du matériau semiconducteur.
